# EUROPEAN PATENT SPECIFICATION

(11) **EP 4 533 458 B1**
(45) Date of publication and mention of the grant of the patent: **11.03.2026**
(21) Application number: 23725746.4
(22) Date of filing: 29.05.2023
(51) Int. Cl.: G11C 13/00, B01J 19/00, G11C 13/02

(54) **ELECTROCHEMICAL SYNTHESIS SYSTEM**
ELEKTROCHEMISCHES SYNTHESESYSTEM
SYSTÈME DE SYNTHÈSE ÉLECTROCHIMIQUE

(30) Priority: 31.05.2022 EP 22176424
(43) Date of publication of application: 09.04.2025
(73) Proprietor: Imec VZW, 3001 Leuven (BE)
(72) Inventor: HENRY, Olivier, 3001 Leuven (BE); WILLEMS, Kherim, 3001 Leuven (BE); FONDU, Jelle, 3001 Leuven (BE); STAKENBORG, Tim, 3001 Leuven (BE); YASIN, Farrukh, 3001 Leuven (BE); LOCKHART DE LA ROSA, Cesar Javier, 3001 Leuven (BE); TAHER, Ahmed, 3001 Leuven (BE); FURNEMONT, Arnaud, 3001 Leuven (BE)
(74) Representative: Winger
(86) International application number: PCT/EP2023/064343
(87) International publication number: WO 2023/232749

(56) References cited:
- US-A- 6 165 778
- US-A1- 2014 193 896
- US-A1- 2019 241 951
- US-A1- 2019 358 604
- US-A1- 2020 265 890
- US-A1- 2021 332 351

## Description

### Technical field of the invention

The present invention relates to the field of electrochemical synthesis systems, and more in particular to the field of memory devices based on such a system.

### Background of the invention

New data is being generated at an exponential rate. Some are consumed as they are generated (e.g., voice over IP), some need to be readily available (e.g., day-to-day information sharing), and some need to be stored, safely, for a long or extremely long time before ever being consulted.

Current technologies used for data archival typically have a lifetime of 10-20 years, consume power, and allow only a relatively low data density.

On the other hand, biopolymers, such as DNA, have been optimized by evolution to store information in a very compact and power-efficient manner for an extremely long time. DNA has therefore emerged as promising support for data encoding and storage.

EP3888783A1 discloses a system for addressing nanoelectrodes in a nanoelectrode array. This system allows a high density of individually addressable electrodes, which is advantageous for achieving a high-density electrochemical memory storage system. Such a system potentially permits the selective synthesis of multiple different biopolymers in parallel on the array of electrodes.

Other approaches have been described in the art. For instance, US 2021/0332351 A1 discloses methods for the massively parallel enzymatic synthesis of polynucleotides on an electrode array where the electrodes are used to control deprotection steps. US 2019/0241951 A1 discloses a more general system for biological analysis which includes capturing, amplifying, and sequencing nucleic acids at electrodes, and mentions its application to data storage.

This is only one piece of the puzzle and the state of the art remains very far from providing a complete working electrochemical synthesis system that would be compatible with high-density information storage. For instance, much progress remains needed before polymers can be used effectively as a memory storage medium. In particular, the synthesis costs remain very high. This is in part due to the cost of the reagents and the speed at which they lose potency upon aging or contamination. Furthermore, the speed at which one nucleotide can be added to a growing polynucleotide chain is currently in the order of 5 to 10 minutes. This is too slow for most uses.

There is therefore a need in the art for new methods and systems overcoming at least partially one or more of these issues.

### Summary of the invention

It is an object of the present invention to provide good systems for the electrochemical synthesis of polymers.

The above objective is accomplished by a system a method of the present invention according to independent claims 1 and 10, respectively.

It is an advantage of the system according to embodiments of the present invention that it is compatible with the presence of a very high density of electrodes, and hence with its use as a high-density memory storage system. That compatibility also enables the use of the system as a reactor for the production of vaccines.

It is an advantage of the system according to embodiments of the present invention that it is compatible with long periods of continuous flow of the liquids out of the reservoirs. This ensures that the system remains clean and that the reactants used remain fresh, thereby increasing monomer incorporation yield and accuracy, and hence increasing recorded data quality.

It is an advantage of the system according to embodiments of the present invention that it enables a high synthesis throughput, and hence the high-speed recording of data.

It is an advantage of the system according to embodiments of the present invention that it enables the use of low reagent volumes. It is, therefore, economical.

It is an advantage of the system according to embodiments of the present invention that it wastes little reagent in the flushing of dead volumes. It is, therefore, economical.

It is an advantage of the system according to embodiments of the present invention that it is compatible with handling reagents in parallel. This increases the synthesis throughput, and hence the speed at which data can be recorded.

It is an advantage of the system according to embodiments of the present invention that it can be automatized, thereby increasing the synthesis throughput and reduce the data storage cost.

Particular and preferred aspects of the invention are set out in the dependent claims.

Although there has been constant improvement, change, and evolution of devices in this field, the present concepts are believed to represent substantial new and novel improvements, including departures from prior practices, resulting in the provision of more efficient, stable, and reliable systems of this nature.

The above and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention as defined by the claims. Likewise, only embodiments of the description comprising all the technical features of the claims fall under the scope of protection of the claims while the remaining ones correspond to illustrative examples which are useful for the understanding of the relevant technical context. The reference figures quoted below refer to the attached drawings.

### Brief description of the drawings

Fig. 1 is a schematic representation of a system according to an embodiment of the present invention.
Fig. 2 is a perspective view of a microfluidic structure as used in embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present (and can therefore always be replaced by "consisting of" in order to restrict the scope to said stated features) and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

A "fluidically coupled" to B means that there exists a path that a fluid can follow to go from A to B or from B to A while A can be directly fluidically coupled to B without intermediate units or A can be indirectly fluidically coupled to B via one or more intermediate units.

A "fluidically directly coupled" to B means that there exists a path that a fluid can follow to go from A to B or from B to A while A is directly fluidically coupled to B without intermediate units.

A "fluidically coupled downstream" to B means that there exists a path that a fluid can follow to go from B to A in the typical flow direction during normal use of the system.

A "fluidically coupled upstream" to B means that there exists a path that a fluid can follow to go from A to B in the typical flow direction during normal use of the system.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

As used herein, and unless provided otherwise, the term "electrochemical synthesis" relates to a synthesis comprising at least one electrochemical step, i.e., at least one step where electrical energy, originating in a power source external to the reaction media, is used to enable or speed up a chemical change. An example of such an electrochemical step is the removal of the protective group of a monomer by electrochemically locally increasing the acidity of a liquid around the protected monomer, said liquid comprising a deprotection solution which becomes acidic when electrochemically activated.

As used herein, and unless provided otherwise, the term "downstream" characterizes the typical liquid flow direction from the plurality of reservoirs to the flow control system to the microfluidic structure to the one or more reaction chambers. Hence, for instance, the microfluidic structure is downstream to the reservoir and the reservoir is upstream to the flow control system.

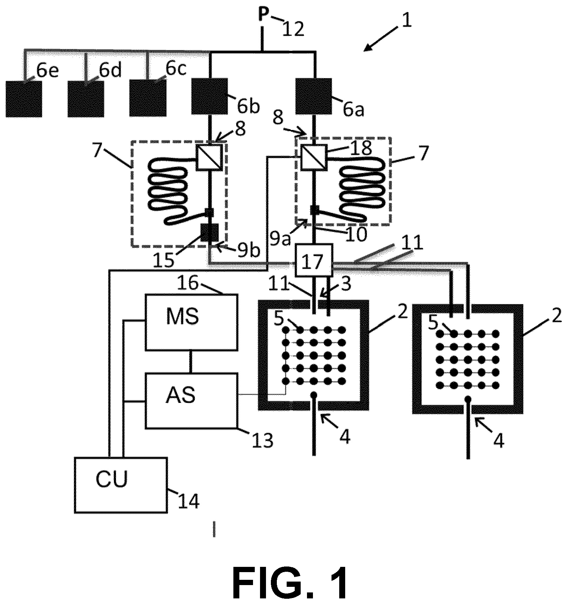

We now refer to Fig. 1. In the first aspect, the present invention relates to a system (1) for the electrochemical synthesis of polymers.

Although the system (1) according to the present invention is suitable for the electrochemical synthesis of both homopolymers and copolymers, it is especially advantageous for the synthesis of copolymers. Furthermore, copolymers have the advantage that information can be stored in the sequence of monomers composing them.

In preferred embodiments, the polymers are copolymers and the system is a memory system for storing data. Preferred copolymers are biopolymers such as polypeptides and polynucleotides. More preferred are polynucleotides such as deoxyribonucleic acid (DNA) strands. For instance, if the copolymer is a DNA strand, the nature of the data is determined by the sequence of bases in the DNA strand.

The system of the first aspect comprises one or more reaction chambers (2). They can also be called supercells.

A single chamber or a plurality of chambers may be comprised in the system. In embodiments, the chambers are arranged as an array of chambers. For instance, the system may comprise 10 or more chambers, such as 100 or more chambers, or 1000 or more chambers. Having multiple small reaction chambers instead of a single large one is advantageous because of the smaller length scale (faster diffusion and lower dead volume).

In embodiments, each chamber may have a length of from 100 µm to 10 mm.

Each reaction chamber (2) comprises:
i. a reaction chamber inlet (3),
ii. a reaction chamber outlet (4),
iii. a plurality of reaction sites, each reaction site comprising one or more individually addressable electrodes (5) for controlling a chemical reaction in that reaction site of the reaction chamber (2).

Preferably, each reaction chamber (2) comprises a plurality of reaction chamber inlets (3). For instance, each reaction chamber (2) may comprise at least as many (e.g., exactly as many) reaction chamber inlets (3) as they are reservoirs. This is advantageous as it allows each reservoir to be fluidically coupled upstream to a reservoir via its own fluidic system (comprising the flow control system and the microfluidic structure), not shared with other reservoirs, thereby guaranteeing a very low contamination level. As another example, each reaction chamber (2) may comprise at least as many reaction chamber inlets (3) (e.g., exactly as many reaction chamber inlets) as there are reservoirs minus the number of monomers. For instance, if there are four monomers and eleven reservoirs, the number of reaction chamber inlets (3) could be equal to at least seven (e.g., exactly seven). This would be typical of a configuration where the monomers are preferably mixed with an activator before to enter the reaction chambers. In such a configuration, a flow control system outlet (9) of the reservoir for containing the activator, and a flow control system outlet (9) for each of the reservoirs for containing a different monomer, are fluidically coupled upstream to a common mixing channel, feeding into the an inlet of the microfluidic structure or directly connected downstream from this inlet.

In embodiments, the reaction chamber (2) may be configured so that the outlet (4) can remove used fluids from the chamber (2). In embodiments, the reaction chamber (2) may be configured so that the outlet (4) can remove used fluids from the chamber continuously, i.e., with the fluid flow out of the outlet remaining non-zero for as long as the system (1) is in operation.

In embodiments, the reaction chamber may be configured so that the outlet for removing the used fluids, or another separate outlet, can remove a plurality of synthesized polymer molecules from the chamber, after they have been detached from their electrodes. If each synthesized polymer molecule comprises in its monomer sequence a signature of the reaction site where it has been synthesised, this removal permits a subsequent reading of the content of the memory by determining the monomer sequence.

In embodiments, the reaction chamber may be configured so that the outlet for removing the used fluids, or another separate outlet, can remove a plurality of identical synthesized polymer molecules from the chamber, after they have been detached from their one or more electrodes at a same reaction site. Indeed, although different reaction sites typically synthesise different copolymer molecules, a plurality of identical copolymer molecules are typically synthesized in each reaction site on the one or more electrodes present therein. In embodiments, the chamber may comprise a driver for moving a plurality of synthesized copolymer molecules from the reaction site(s) where they have been synthesized to the outlet for removing used fluids, or another separate outlet. This facilitates further processing of the synthesized copolymer molecules such as separation, purification, copy, and/or storage. The driver can for instance be a dielectrophoresis structure configured for moving a synthesized copolymer from an electrode where it has been synthesized to the outlet for removing the used fluids, or another separate outlet.

In embodiments, the chamber may comprise a holder upstream of the outlet for removing the used fluids, or another separate outlet. The holder may be suitable for concentrating a plurality of synthesized copolymer molecules after they have been released from their reaction site(s). For instance, the holder can be a dielectrophoresis structure.

In embodiments, each chamber may comprise a heater to control the reaction temperature. In embodiments, the control unit (14) can be configured for piloting the heater.

In embodiments, the number of reaction sites in a chamber can be 30,000 reaction sites or more, preferably 100,000 or more, more preferably 1,000,000 or more, yet more preferably 10,000,000 or more, yet more preferably 100,000,000 or more, yet more preferably 1,000,000,000 or more. EP 3888783 discloses a technology enabling such numbers.

In embodiments, the density of reaction sites may be 15,000/cm² or more, preferably 50,000/cm² or more. For instance, the density of reaction sites may be 200,000/cm² or more, 500,000/cm² or more, 1,000,000/cm² or more, or 10,000,000/cm² or more, 100,000,000/cm² or more.

Each chamber comprises a plurality of reaction sites. Typically, the reaction sites collectively form an array, i.e., they are typically arranged in a regular fashion such as in a series of parallel rows and parallel columns with the rows being perpendicular to the columns. Other arrangements (e.g. a hexagonal packing) of the array can likewise be envisioned. Reaction sites can also be referred to as cells.

At each reaction site, a plurality of (typically identical) copolymer molecules can be synthesized on the one more electrodes comprised in that reaction site. The chamber may be adapted so that a synthesis step occurring at one reaction site does not cause a synthesis step at another reaction site. Hence, the chamber enables the spatially controlled synthesis of copolymers, and preferably the spatially controlled synthesis of copolymers by sequentially adding monomers to a growing copolymer strand. In other words, the chamber can be adapted so that the reaction conditions are confined for each reaction site. When the confinement results from the chamber's adaptation, it is typically physical. The confinement can also be electrochemical. In that case, it typically results from the addressing system configuration.

For instance, for the reaction conditions to be confined by physical means, the reaction chamber may comprise a plurality of reaction sites on a substrate and a perforated cover layer over the plurality of reaction sites. The perforated cover layer may comprise cavities which overlay and open up the reaction sites at the bottom thereof. As such, each cavity physically confines a reaction site in which the walls that define the cavity hinder the diffusion of the reaction medium from one reaction site to the next, thereby locally confining the reaction medium and thus the reaction conditions.

On the other hand, for the confinement to be achieved electrochemically, no perforated cover layer is needed. It can, however, be present to combine physical and electrochemical confinement. Instead, confinement may be achieved by making counteractive the electrodes comprised in the reaction sites surrounding the reaction site where the polymer is to be synthesised (i.e., the active reaction site), so that the opposite reaction occurs in these surrounding reaction sites. For instance, protons can be generated (e.g., by oxidizing hydroquinone to benzoquinone) at the active reaction site, and can be consumed in the surrounding reaction sites (e.g., by reduction of benzoquinone back to hydroquinone). Thus, as the produced protons start to diffuse away from the active reaction site where the polymer is to be synthesized, they are consumed at the surrounding reaction sites. Hence, even in the absence of physical boundaries, the reaction conditions are still confined to the desired reaction site.

In embodiments where the reaction sites are arranged in a series of parallel rows and parallel columns with the rows being perpendicular to the columns, the non-active reaction sites directly above, below, left, and right of any active reaction site may be set to be counteractive, thereby confining the reaction.

In embodiments, each reaction site may comprise one or more electrode cells as described in EP3888783. In particular, the plurality of reaction sites can be an array of reaction sites, the array comprising an array of electrode cells, each electrode cell comprising (i) an access transistor having a gate resistively coupled to a word line, a source resistively coupled to a bit line, and a drain; and (ii) a storage circuit resistively coupled to the drain and comprising an individually addressable electrode. A reaction site can comprise a single electrode cell or a sub-array of such electrode cells.

In embodiments, the array of electrode cells may comprise one or more rows, the electrode cells in a row being linked by a common word line, and/or one or more columns, the electrode cells in a column being linked by a common bit line. In embodiments, the electrode cells may be arranged in a cubic packing, hexagonal packing or any other suitable arrangement.

In embodiments, the storage circuit may comprise the individually addressable electrode and an electrical connection (e.g., wire) resistively coupling the nanoelectrode to the drain.

In embodiments, the storage circuit may further comprise a capacitor. In embodiments, the capacitor may have a terminal resistively coupled to both the drain and the individually addressable electrode (i.e. the same terminal may be coupled to both). In some embodiments, the capacitor may be a separate (i.e. distinct) capacitor; i.e. the capacitor may be an electrical component solely dedicated to that role.

In other alternative or complementary embodiments, an electrical component may perform the role of a capacitor and one or more further functions. For example, a capacitor may be formed about the electrical connection coupling the drain to the individually addressable electrode, so that the ensemble simultaneously fulfills the role of the electrical connection and capacitor. Such a capacitor could for instance be achieved by wrapping the electrical connection with a dielectric and then wrapping a counter electrode around the dielectric. In yet other alternative or complementary embodiments, through their inherent parasitic capacitance (e.g. wire capacitance), the storage circuit and/or the electrical connection as such may be regarded as a capacitor.

In embodiments, the storage circuit may have a capacitance of at least 0.01 fF, preferably at least 1 fF, more preferably at least 10 fF, yet more preferably at least 20 fF, such as at least 30, 50, 100, 200, or 500 fF.

Especially in combination with a suitable refresh rate (e.g., 64 ms or more; cf. infra), such a capacitance in particular in the order of 10 fF (e.g. about 30 fF) or more should typically allow storing enough charge in order to drive an electrochemical reaction for a sufficient time (e.g. until the next refresh) to for instance enable or disable a synthesis reaction within a synthesis cell above the electrode. The refresh rate is the duration between the start times of subsequent repetitions of the step of setting the selected potentials by, for each electrode cell, opening the access transistor by asserting the word line and charging the storage circuit to the selected electrode potential by aptly biasing the bit line.

In embodiments, the capacitance of the storage circuit may be partially or entirely due to a parasitic capacitance (e.g. wire capacitance) of the storage circuit. In embodiments, the capacitor may have a capacitance of at least 0.01 fF, preferably at least 1 fF, more preferably at least 10 fF, yet more preferably at least 25 fF, most preferably at least 30 fF, such as at least 30, 50, 100, 200 or 500 fF. It is worth noting that there is also a practical upper limit to the capacitance in that charging the storage circuit takes longer when the capacitance thereof is higher. As such, a favorable range for the capacitance may be from about 20 to about 500 fF when using a front-end-of-line (FEOL) access transistors, and from about 1 to 25 fF when using a back-end-of-line (BEOL; cf. infra) transistor.

In embodiments, the access transistors and optionally the electrode cells as a whole may be formed on a semiconductor substrate (e.g., a Si, Ge, SiGe or semiconductor-on-insulator substrate). In embodiments, the access transistor may be a planar transistor (e.g., a planar field-effect transistor, planar FET) or a vertical transistor (e.g., a vertical FET, VFET). In embodiments, the access transistor may be a back end of line (BEOL) transistor; i.e., a transistor formed during the BEOL stage of semiconductor processing. The access transistor may for example be a thin film metal-oxide-semiconductor FET (MOSFET), such as based on an indium gallium zinc oxide (IGZO), polysilicon, 2D material (e.g., MoS₂, MoSe₂, MoTe₂, WS₂ or WSe₂) thin film. The use of BEOL access transistors advantageously allows to dedicate the front end of line (FEOL) region below the electrode cell array for peripheral circuits (e.g. write drivers, refresh circuits and/or data transfers).

In embodiments, the electrodes are nanoelectrodes, i.e., electrodes having at least one lateral dimension (e.g., a diameter) measuring 100 nm or less, preferably from 10 to 100 nm. Such small dimensions allow for a high density of electrodes, which is beneficial in terms of cost per incorporated monomer.

In embodiments, the distance between two neighboring individually addressable electrodes may be from 10 to 95 nm. Such a small distance allows for a high density of electrodes, which is beneficial in term of cost per incorporated monomer.

In embodiments, the nanoelectrodes (e.g., the nanoelectrode array) may have a pitch (i.e., a centre-to-centre distance between adjacent nanoelectrodes) of 1 mm or less, preferably 500 nm or less, more preferably 250 nm or less, yet more preferably 150 nm or less, such as 100 nm or less. The currently most advanced DRAM nodes for example use a hexagonal layout (e.g., of the capacitors) with a pitch of about 30 nm, illustrating that the aforementioned dimensions are well within the current technological capabilities.

In preferred embodiments, the metal forming the electrode may be Pt or Ru but any conductive material is suitable.

In embodiments, the individually addressable electrodes may comprise a graphene oxide on a surface thereof. Electrodes having a graphene oxide on a surface thereof are the subject of the fifth aspect of the present invention. Each individually addressable electrode of the first aspect may be as described in the fifth aspect of the present invention.

In embodiments, the individually addressable electrodes may comprise an ion-releasing layer on a surface thereof, said ion-releasing layer being configured for releasing ions acting as reactants in the synthesis of the polymer, or ions providing catalytic effect on the synthesis of the polymer.

In embodiments, the number of individually addressable electrodes may be equal to the number of reaction sites. In other embodiments, it may be an integral multiple thereof.

The electrodes can be addressed individually by the addressing system. As used herein, addressing an electrode refers to causing an electrode to function.

In embodiments, addressing an electrode may cause an electrode to be set at a different potential than when the electrode is not addressed. In embodiments, addressing an electrode may operate the electrode potentiostatically, galvanostatically, or potentiodynamically.

Typically, by addressing an electrode, it is meant applying a potential or delivering a current to said electrode. In embodiments, the addressing system has simultaneously the capability to address the electrodes individually or in a group. In such an embodiment, any sub-group of the one or more individually addressable electrodes can be addressed simultaneously. This allows adding a same monomer simultaneously to all growing copolymers attached to said sub-group. By simultaneously, it is meant that all electrodes of the sub-group can be addressed by the addressing system within a total time of less than 100 ms. This total time being at least one order of magnitudes shorter than the time needed for a chemical reaction to be completed (typically seconds), the addressing of the electrodes can be considered as being simultaneous.

In embodiments, when each reaction site comprises an electrode cell as described in EP3888783, the control unit may be configured to cause the addressing system to select a potential for each electrode, and for setting the selected potentials by, for each electrode cell, opening the access transistor by asserting the word line and charging the storage circuit to the selected electrode potential by aptly biasing the bit line.

In general, the control unit may be configured to cause the addressing system to set each individually addressable electrode to be active, neutral, or counteractive. 'Active', 'neutral', and 'counteractive' here refer to the electrochemical activity of the nanoelectrode: an active electrode has a suitable potential for bringing about a particular electrochemical reaction, a counteractive electrode has a suitable potential for bringing about a different reaction (e.g. the opposite reaction, in so far as the electrochemical reaction is reversible) and an inactive electrode has an intermediate potential which is neither sufficient to bring about the particular electrochemical reaction nor its opposite. In embodiments, the control unit may be configured to cause the addressing system to select more negative potentials for the nanoelectrodes which are to be active, and intermediate potentials for the nanoelectrodes which are to be inactive and/or more positive potentials for the nanoelectrodes which are to be counteractive. In other embodiments, the control unit may be configured to cause the addressing system to select more positive potentials for the nanoelectrodes which have to be active, and intermediate potentials for the nanoelectrodes which have to be inactive and/or more negative potentials for the nanoelectrodes which have to be counteractive. In the above, rather than referring to absolute values, the potentials are expressed relative to one another. Indeed, the specific potential values will, i.a., typically depend on the reference point that is selected (e.g. ground or a counter-electrode contacting the reaction medium). As such, a 'more negative' potential may in some instances still be positive, etc. Regardless of the reference point selected, however, suitable potentials for setting an individually addressable electrode to active, inactive, or counteractive for a particular electrochemical reaction can typically be calculated (e.g., based on theory or modelling) or can be derived by relatively simple and straightforward trial-and-error.

The control unit may be configured to cause the addressing system to make in order that the confinement of the reaction is achieved electrochemically.

Each time one or more individually addressable electrodes are addressed, a reaction can occur at these electrodes if suitable reagents are present, thereby causing the growing copolymer to add one monomer to its growing chain. This can for instance comprise: (a) setting the potential of the one or more electrodes, and (b) contacting one or more reagents with the electrodes; thereby locally forming an electrochemical environment for mediating the synthesis.

One or more counter electrodes, for example arranged in a counter electrode array, are also typically present in each reaction chamber. These may for example be situated above the individually addressable electrodes (e.g., nanoelectrode array). For instance, if a perforated cover layer is present over the plurality of reaction sites, the one or more counter electrodes can be atop and in physical contact with the perforated cover layer or further above. Each individually addressable electrode is then typically associated with a counter electrode. However, it is also possible that one counter electrode may be associated with a plurality of individually addressable electrodes. This is easier to implement than having as many counter-electrodes as there are individually addressable electrodes.

The system further comprises a plurality of reservoirs (6) for containing liquids.

The system comprises at least two reservoirs. This allows the dedication of one reservoir to a washing solution and another reservoir to a monomer. However, a single monomer only permits the formation of a homopolymer. This is of limited use in many applications.

Preferably, the system comprises at least three reservoirs. This allows the dedication, in addition to the reservoirs above, of another reservoir for a second comonomer. This is advantageous as it allows the formation of copolymers, which can store information in their monomer sequence.

More preferably, the system comprises at least four reservoirs. This allows the dedication, in addition to the reservoirs above, of one reservoir for a deprotection solution. In many synthesis schemes, the deprotection of a protected monomer requires the presence of a dedicated reagent. This is for instance the case for typical polynucleotide synthesis schemes.

Even more preferably, the system comprises at least five reservoirs. This allows the dedication, in addition to the reservoirs above, of one reservoir for an activator solution. In typical polynucleotide synthesis schemes, an activator solution is preferably delivered together with a protected monomer to enable or speed up the deprotection.

Yet even more preferably, the system comprises at least six reservoirs. This allows the dedication, in addition to the reservoirs above, of one reservoir for an oxidative solution. In typical polynucleotide synthesis schemes, the phosphite triester backbone of added building blocks is oxidized into a more stable teteracoordinated phosphate triester.

Yet still more preferably, the system comprises at least seven reservoirs. This allows the dedication, in addition to the reservoirs above, of one reservoir for a capping solution. In typical polynucleotide synthesis schemes, a capping solution is delivered to permanently block non-reacted hydroxyl groups that could remain in case of incomplete coupling.

Most preferably, the system comprises at least nine reservoirs. This allows the dedication, in addition to the reservoirs above, of two additional reservoirs to two further comonomers. This way four different comonomers are enabled, which allows typical polynucleotide synthesis involving four different bases.

Further reservoirs can be added, for instance, to enable different capping solutions or to add further comonomers.

Any size of reservoir is suitable. Typically, each reservoir may have a volume ranging from 0.1 to 10 ml.

The system further comprises at least one flow control system (7) for selecting a flow rate at which a liquid will be delivered from one or more of said plurality of reservoirs (6) to the flow control system outlet (9), comprising:
i. at least one flow control system inlet (8), wherein each reservoir (6) is fluidically coupled upstream to a flow control system inlet (8),
ii. at least one flow control system outlet (9).

Preferably, the number of flow control systems corresponds to the number of reservoirs. In other words, each reservoir (6) may be fluidically coupled upstream to a different flow control system (7). This has the advantage that a prolonged use of the system is possible without a need for washing the flow control systems. This avoids the wasting of reagent that would otherwise occur during the flushing out of reagent dead volumes prior to introducing a different reagent. This has the further advantage that each reservoir can continuously deliver liquid to the flow control system. A continuous flow out of the reservoir ensures that the liquids delivered to the reaction chamber are always fresh. It also prevents backflow and back diffusion of one reagent into another. This speeds up the chemical reactions at the cost of a higher reagent consumption. Overall, however, it is beneficial to the cost per stored data by enabling a continuous, high fidelity, data storage. A further advantage is that the parallelized handling of reagents is enabled.

In embodiments, the first flow rate may be from 0.1 nL/s to 10 nL/s per reaction chamber. In embodiments, the second flow rate may be from 0.1 pL/s to 2 nL/s, preferably from 0.1 pL/s to 10 pL/s per reaction chamber. A relatively low flowrate is advantageous as it limits the reagent consumption

In embodiments, the at least one flow control system (7) may be adapted for selecting between delivering a liquid to the flow control system outlet at a first flow rate and delivering the liquid to the flow control system outlet at a second flow rate, different from the first flow rate. In these embodiments, the at least one flow control system may comprise a three-way valve comprising a three-way valve inlet fluidically coupled downstream to the flow control system inlet, a first three-way valve outlet fluidically coupled upstream to the flow control system outlet, and a second three-way valve outlet fluidically coupled upstream to the flow control system outlet, wherein the flow control system (7) is configured for delivering the liquid to the flow control system outlet at the first flow rate when the first three-way valve outlet is open and the second three-way valve inlet is closed, and at the second flow rate when the first three-way valve outlet is closed and the second three-way valve inlet is open. Preferably, the second flow rate is non-zero. For instance, the first flow rate is at least five times, preferably at least 50 times, more preferably at least 250 times, yet more preferably from 500 to 2000 times larger than the second flow rate and the second flow rate is non-zero. A non-zero second flowrate has the advantage of preventing backflow or back diffusion of one reagent into another.

In embodiments, the three-way valve may be electrically controllable.

In embodiments, the selection between delivering the liquid to the flow control system outlet at a first flow rate and delivering the liquid to the flow control system outlet at a second flow rate may be performed electrically, for instance via the electrically controlled three-way valve. This valve can be piloted by the control unit.

In embodiments, the at least one flow control system (7) may comprise a first and a second microfluidic channel (e.g. tubes) wherein the first microfluidic channel is adapted for presenting a lower hydraulic resistance than the second microfluidic channel. For instance, the first microfluidic channel may have a diameter which is larger than the diameter of the second microfluidic channel, may have a length which is shorter than the length of the second microfluidic channel, or both.

In embodiments, the first microfluidic channel has an inlet fluidically coupled downstream to the first three-way valve outlet and the second microfluidic channel has an inlet fluidically coupled downstream to the second three-way valve outlet.

In embodiments, the first three-way valve outlet may comprise the first microfluidic channel and the second three-way valve outlet may comprise the second microfluidic channel.

In embodiments, the outlets of the first and second microfluidic channels are both fluidically coupled upstream to the outlet of the flow control system.

In embodiments, the at least one flow control system may be adapted for selecting between not delivering the liquid to the flow control system outlet, delivering the liquid at the first low rate, or delivering the liquid at the second flow rate. Although the device fulfils its functions without the possibility of not delivering the liquid, it is advantageous to allow the liquid not to be delivered at all, for instance, to clean the reaction chamber, when the reaction chamber is placed or removed, or when the system is not in use. This can, for example, be implemented by having the at least one flow control system comprising a two-way valve (15) comprising a two-way valve inlet fluidically coupled downstream to the flow control system inlet and a two-way valve outlet fluidically coupled upstream to the flow control system outlet, wherein the flow control system (7) is configured for not delivering the liquid to the flow control system outlet when the two-way valve is closed and for delivering the liquid to the flow control system outlet when the two-way valve is open. When present, one such two-way valve per flow control system is typical. In embodiments, the two-way valve can be fluidically coupled downstream to the three-way valve and upstream to the flow control system outlet. Alternatively, the two-way valve can be fluidically coupled upstream to the three-way valve and downstream to the flow control system inlet.

Typically, one flow control system inlet is present per flow control system and per reservoir.

Typically, one flow control outlet is present per flow control system.

Typically, one flow control inlet is present per flow control system.

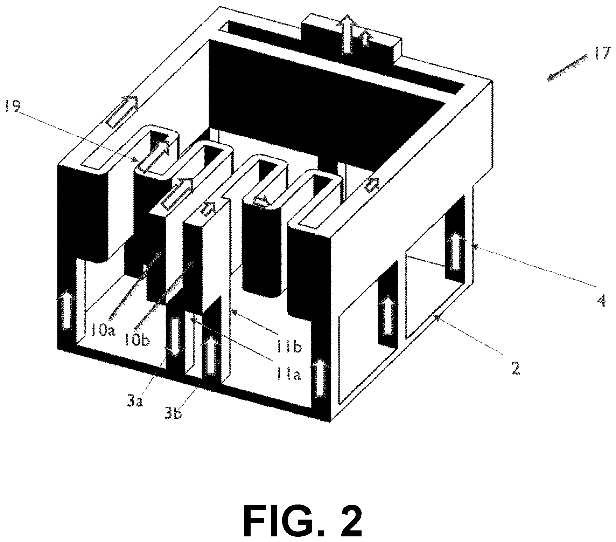

The system further comprises a microfluidic structure (17, see e.g., Fig. 2) comprising:
i. at least one microfluidic structure inlet (10) fluidically coupled downstream to a flow control outlet (9),
ii. at least one microfluidic structure outlet (11) per reaction chamber (2), each microfluidic structure outlet (11) being fluidically coupled upstream to a reaction chamber inlet (3).

The use of a microfluidic structure allows the system of the present invention to handle very small reagent volumes. Another consequence of the use of a microfluidic structure is that the dead volumes can be very small.

The microfluidic structure preferably comprises at least one microfluidic channel, i.e., a channel having a width of 100 µm or less.

The microfluidic structure has at least one inlet. Preferably, it has one inlet per reservoir.

The microfluidic structure has at least one outlet. In embodiments, it may have two outlets, one for the synthesised copolymer and one for the waste.

In embodiments, the microfluidic structure may be fluidically connected downstream to all flow control systems (7), wherein at least one of said flow control systems is set to deliver to the microfluidic structure (17) a liquid at a relatively higher flow rate, higher than a relatively lower flow rate of the one or more liquids delivered by the remaining other flow control systems (7), and wherein the microfluidic structure (17) is configured for distributing between all of the one or more reaction chambers (2) said liquid delivered at a relatively high flow rate and for diverting away from all reaction chambers (2) the other liquids delivered at a relatively lower flow rate. By the higher flow rate, it is typically meant the largest of both possible non-zero flow rate exiting the flow control system. This is, for instance, the second, fourth, sixth, and eighth flow rate of the washing solution, the second flow rate of the deprotecting solution, the second flow rate of the protected monomer solution, the second flow rate of the activator solution, and the second flow rate of the capping solution. By the lower flow rate, it is typically meant the smallest of both possible non-zero flow rate exiting the flow control system. This is, for instance, the first, third, fifth, and seventh flow rates of the washing solution, the first flow rate of the deprotecting solution, the first flow rate of the protected monomer solution, the first flow rate of the activator solution, and the first flow rate of the capping solution.

In embodiments, the microfluidic structure (17) may be present above (i.e., at a higher elevation than) the one or more reaction chambers (2). This saves footprint. In embodiments, the microfluidic structure (17) may be integral with the one or more reaction chambers (2).

The system comprises a plurality of pressurizeable reservoirs, i.e., reservoirs adapted for being pressurized.

The system may further comprise pressurizing means (12) configured for pressurizing the plurality of reservoirs (6).

Preferably, the pressurizing means are configured for permitting the tuning of the pressure in each reservoir individually. This is advantageous because it permits tuning the flowrate of each reservoir. Preferably, the pressurizing means are configured so that, in the hypothetical absence of flow control system, the flowrate out of all reservoirs would be the same. This simplifies the system.

For instance, each reservoir could be pressurized by its own independent pressurizing means. It is also possible to have a single pressurizing means fluidically coupled to the plurality of reservoirs via a corresponding plurality of valves, said valves allowing to tune the pressure.

It is also possible to have a single pressurizing means directly fluidically coupled to the plurality of reservoirs, i.e., without means for tuning the pressure individually in each reservoir.

Examples of pressurizing means are those that operate on the basis of mechanical principles (e.g., external syringe pumps, pneumatic membrane pumps, vibrating membrane pumps, piezoelectric/ultrasonic pumps, ...), and those that operate on the basis of electrical or magnetic principles (e.g., electrokinetic pumps, electrohydrodynamic pumps, magnetohydrodynamic pumps, ...), amongst others.

Preferably, the pressurizing means allows the direct control (i.e., the tuning) of the pressure. A pressurizing means only allowing the indirect control of the pressure via, e.g., the flowrate could lead to an overpressure if there is a blockage in the system. For this reason, syringe pumps are less preferred.

The system further comprises an addressing system (13) configured for addressing the electrodes (5) individually.

In embodiments, the addressing system comprises a multiplexer device and a source measurement unit.

The multiplexer device is configured to allow any arbitrary set of the individually addressable electrodes to be turned on or off at a chosen time (e.g., before, during, or after the synthesis depending on the specific synthesis step (characterization, functionalization, detritylation, strand release, ...)).

In embodiments, the multiplexer device may be a separate device connected to the individually addressable electrodes through external wiring. In other embodiments, the multiplexer device may be incorporated into the microfluidic chip itself (e.g., using CMOS technology).

In embodiments, the source measurement unit may be a potentiostat device, i.e., a device capable of applying a specific electric potential. In embodiments, the source measurement unit may be a galvanostat device, i.e., a device capable of delivering a set amount of current. In embodiments, the source measurement unit may be able to switch operation between operating as potentiostat device and a galvanostat device.

In embodiments, the source measurement unit may be a separate device connected to the input signal of the multiplexer device through external wiring. In other embodiments, the source measurement unit may be incorporated into the microfluidic chip itself (e.g., using CMOS technology).

The system further comprises a control unit (14) configured for piloting:
i. the addressing system (13), and
ii. the at least one flow control system (7).

In embodiments where a measuring system (16) is present, the control unit may be further configured for piloting iii. The measuring system (16).

The control unit can be a switchboard to be operated manually but is more practically, more typically, and more advantageously a computer.

In embodiments, the control unit may be programmed to pilot the addressing system and the at least one flow control system in such a way that a copolymer having a predefined monomer sequence is independently synthesized in each reaction site. The programming can be in hardware or in software.

In other words, the control unit may be programmed in hardware or software to accept a series of data as an input, and converts it into a set of DNA strands assigned to the electrodes (e.g., a unique sequence for each electrode), and formulates and executes a set of actions for the flow control system and the addressing system to achieve the synthesis of these strands.

In embodiments, the control unit can be adapted for piloting the addressing system so that it turns on or off any set of electrodes amongst the individually addressable electrodes.

In embodiments, the control unit can be adapted for piloting the multiplexer device, the source measurement unit, or both.

In embodiments, the control unit can be adapted for selecting the flow rate at which a liquid will be delivered from one or more of said plurality of reservoirs (6). For instance, when the flow control system comprises valves, the control unit system can be configured for causing said valves to select a flow rate, and optionally, to interrupt the flow altogether.

In embodiments, the control unit may use input data coming from at least one reaction site of a reaction chamber to pilot the addressing system and the at least one flow control system. The input data can, for instance, be collected by a sensor, such as an electrical sensor. Typically, one sensor per reaction chamber is sufficient but more sensors per reaction chamber can be present.

In other words, in embodiments, the system may further comprise a measuring system (16) configured for measuring an electrical property in a reaction chamber (2) at at least one of said reaction sites. For instance, the electrical property may be selected from a voltage, a Faradaic current, an impedance, or a capacitance. The voltage or the Faradaic current could be associated, for instance, to an electrochemical reaction occurring at the electrode. Preferably, the electrical property is capacitance.

In embodiments, the control unit (14) is further configured for receiving the measurement of the electrical property, or a signal depending on this measurement, from the measuring system (16), and using this electrical property or signal to pilot the addressing system (13) and/or the at least one flow control system (7).

In embodiments, the control unit (14) may be configured for automatically executing the method according to any embodiment of the second aspect.

Fig. 1 depicts schematically a system according to an embodiment of the present invention. It comprises:
a. one or more reaction chambers (2, two are depicted), each chamber (2) comprising:
   i. at least one reaction chamber inlet (3, two are depicted),
   ii. a reaction chamber outlet (4),
   iii. a plurality of reaction sites, each reaction site comprising one or more individually addressable electrodes (5) for controlling a chemical reaction in that reaction site of the reaction chamber (2),
b. a plurality (five are depicted) of pressurizeable reservoirs (6) for containing liquids,
c. at least one flow control system (7, two are depicted but as many are present as there are reservoirs (6)) for selecting a flow rate at which a liquid will be delivered from one or more of said plurality of reservoirs (6) to the flow control system outlet (9a, 9b), comprising:
   i. at least one flow control system inlet (8), wherein each reservoir (6) is fluidically coupled upstream to a flow control system inlet (8),
   ii. at least one flow control system outlet (9a, 9b).

Two examples of flow control systems are depicted. The left flow control system is adapted for selecting between not delivering the liquid to the flow control system outlet (9), delivering the liquid to the flow control system outlet (9) at the first flow rate, or delivering the liquid to the flow control system outlet (9) at the second flow rate. The right flow control system cannot not deliver the liquid to the flow control system outlet (9).

The system further comprises:
d. a microfluidic structure (17) comprising:
   i. at least one microfluidic structure inlet (two are depicted, 10a, 10b) fluidically coupled downstream to the two flow control system outlets (9a, 9b),
   ii. at least one microfluidic structure outlet (11) per reaction chamber (2) (two are depicted per reaction chamber), each microfluidic structure outlet (11a, 11b) being fluidically coupled upstream to one or more reaction chamber inlets (3, here to four such inlets),
e. an addressing system (13) configured for addressing the electrodes (5) individually, and
f. a control unit (14) configured for piloting:
   i. the addressing system (13), and
   ii. the at least one flow control system (7).

Fig. 2 depicts a perspective view of a microfluidic structure (17) as used in embodiments of the present invention. The microfluidic structure (17) of Fig. 2 comprises two microfluidic inlets (10a, 10b) fluidically coupled downstream to a corresponding number of flow control system outlets (9a, 9b, see Fig. 1). In Fig. 2, the outlets (11a, 11b) of the microfluidic structure (17) are depicted fluidically coupled upstream to a single reaction chamber (2) via two reaction chamber inlets (3a, 3b). The long white arrows depict the fluidic path taken by a liquid delivered to the inlet (10a) at a higher flow rate. The short white arrows depict the fluidic path taken by a liquid delivered to another inlet (10b) at a lower flow rate than the first flow rate. As can be observed, the liquid delivered at a high flow rate enters both an inlet (10a) and a side drain (19). Via the inlet (10a), the high flow rate liquid enters the reaction chamber (2), fills it entirely, then exits it by the top at a plurality of reaction chamber outlets (4) (one would be enough) but also at the second reaction chamber inlet (3b), thereby preventing the lower flow rate liquid from entering it. The liquid delivered at a low flow rate enters the microfluidic structure inlet (10b) but is blocked from entering the reaction chamber inlet (3b) because of the presence of the high flow rate liquid. The low flow rate liquid, therefore, is entirely diverted to the side drain (19) together with the high flow rate liquid.

The microfluidic structure depicted in Fig.2 has two microfluidic structures inlets (10a, 10b) but a similar microfluidic structure can be designed having as many microfluidic structure inlets (10) as there are pressurizable reservoirs (6).

The microfluidic structure depicted in Fig.2 is connected upstream from a single reaction chamber (2) but a similar microfluidic structure can be connected upstream to all of the one or more reaction chambers (2) of the system (1).

In a second aspect, the present invention relates to a method for synthesizing an oligomer or a polymer in a reaction chamber (2) of the system (1) according to any embodiment of the first aspect wherein:
- the one or more individually addressable electrodes (5) of at least one of said reaction sites have a first protected monomer, oligomer, or polymer, attached to a surface thereof, and
- the plurality of reservoirs (6) includes a first reservoir (6a) comprising a washing solution, a second reservoir (6b) comprising a deprotecting solution, and a plurality of further reservoirs (6d, 6e), each containing a different protected monomer solution,
said method comprising:
a. deprotecting the protected monomer, oligomer, or polymer by:
   i. causing the control unit (14) to pilot the flow control system (7) so that:
      a first flow rate of the washing solution, lower than a second flow rate of the washing solution, is delivered from the first reservoir (6a) to the one or more reaction chambers (2),
      a second flow rate of the deprotecting solution, higher than a first flow rate of the deprotecting solution, is delivered from the second reservoir (6b) to the one or more reaction chambers (2),
   ii. causing the control unit (14) to pilot the addressing system (13) so that a potential is applied, or a current is delivered, to said one or more individually addressable electrodes (5) of said at least one of said reaction sites, thereby deprotecting the first protected monomer, oligomer, or polymer, wherein step i. and ii. overlap,
   iii. then, causing the control unit (14) to pilot the flow control system (7) so that:
      the second flow rate of the washing solution is delivered from the first reservoir (6a), and
      the first flow rate of the deprotecting solution is delivered from the second reservoir (6b),
b. reacting a protected monomer with the deprotected monomer, oligomer, or polymer by:
   i. causing the control unit (14) to pilot the flow control system (7) so that:
      a third flow rate of the washing solution, lower than a fourth flow rate of the washing solution, is delivered from the first reservoir (6a),
      a second flow rate of a protected monomer solution, higher than a first flow rate of the protected monomer solution, is delivered from one of the further reservoirs (6d, 6e),
   ii. then, causing the control unit (14) to pilot the flow control system (7) so that:
      the fourth flow rate of the washing solution is delivered from the first reservoir (6a),
      the first flow rate of the protected monomer solution is delivered from said one of the further reservoirs (6d, 6e) of step b. i., and
c. optionally repeating steps a and b in sequence one or more times.

The first protected monomer, oligomer, or polymer is made unreactive by the presence of a protective group which blocks a reactive group. Typically, the monomer, oligomer, or polymer is a growing polynucleotide strand, the protective group is a dimethoxytrityl group, and the reactive group is an hydroxyl group.

The first protected monomer, oligomer, or polymer is typically covalently attached to a surface of the one or more individually addressable electrodes via a reactive group present on this surface. In the case of polynucleotide synthesis, this reactive group is typically a hydroxyl group.

The washing solution is used between monomer addition steps to prevent contamination from one monomer addition step to the next. In the case of polynucleotide synthesis, the washing solution is typically acetonitrile.

The deprotecting solution is used to allow the removal of the protective group. In embodiments, the deprotecting solution is selected in such a way that the deprotection only occurs at an electrode when this electrode is addressed in presence of the deprotecting solution, e.g., when a particular potential is set at that electrode. In the case of polynucleotide synthesis, when the protective group is a dimethoxytrityl group, the deprotecting solution may be a detritylation solution (e.g., hydroquinone/benzoquinone/lutidine in acetonitrile/MeOH).

In the case of polynucleotide synthesis, the different protected monomer solutions are at least two solutions, typically four solutions, each of which comprising a particular nucleoside phosphoramidite.

In embodiments, a third reservoir (6c) may be present in addition to the first, second, and further reservoirs, and may comprise an activator solution for enabling or speeding up the coupling of a protected monomer with an unprotected monomer, oligomer or polymer attached to a surface of the electrode. In these embodiments, in step b.i., a second flow rate of the activator solution, higher than a first flow rate of the activator solution, may be delivered from the third reservoir (6c), and in step b.ii., a first flow rate of the activator solution may be delivered from the third reservoir (6c).

In the case of polynucleotide synthesis, the activator solution may be an acidic azole catalyst such as 1H-tetrazole.

Steps ai and aii overlap. The overlapping is typically such that step aii is active when the deprotection solution is in contact with the individually addressable electrodes of the at least one of said reaction sites.

In embodiments, the system (1) for electrochemical synthesis of copolymers further comprises a measuring system (16) configured for measuring an electrical property in a reaction chamber (2) at at least one of said reaction sites, wherein:
- step a comprises a sub-step of causing the control unit (14) to pilot the measuring system (16) so that the electrical property in the reaction chamber (2) is measured at said at least one of said reaction sites, and wherein the presence or absence of a further step a.iv. of cycling steps a.i. to a.iii. a number of times depends on the measured electrical property, and if the further step a.iv. is present, the number of cycles depends on the measured electrical property, and/or
- step b comprises a sub-step b.iii. of causing the control unit (14) to pilot the measuring system (16) so that an electrical property in the reaction chamber (2) is measured at said at least at least one of said reaction sites, and wherein the presence or absence of a further step b.iii. of cycling steps b.i. and b.ii. a number of times depends on the measured electrical property, and if the further step b.iii is present, the number of cycles depends on the measured electrical property.

In embodiments, step b. i. may be performed so that the second flow rate of the protected monomer solution (and the second flow rate of the activator solution if present) is delivered from the one of the further reservoirs (6d, 6e) (and from the third reservoir (6c) respectively if the activator is used) until the electrode (5) is in physical contact with this solution, followed by slowing down the delivery of this solution (e.g., setting the delivery of this solution to its first flow rate) or stopping the delivery of this solution (or these solutions if the activator is used), thereby keeping the electrode (5) in physical contact with this solution for from 1s to 600s before step b.ii is performed. In this embodiment, stopping or slowing down the delivery of the protected monomer solution (and of the activator if present) has the effect of reducing the consumption of this (or these) reactant(s). This step of refreshing the solution increases the speed of the reaction.

In embodiments, step b. i. may be performed so that the second flow rate of the protected monomer solution (and the second flow rate of the activator solution if present) is delivered from the one of the further reservoirs (6d, 6e) (and from the third reservoir (6c) respectively if the activator is used) until the chamber is filled.

In embodiments, step b may comprise a step i', between step i and step ii, of causing the control unit (14) to pilot the addressing system (13) so as to activate said one or more individually addressable electrodes (5) of said at least one of said reaction sites in such a way as to attract the protected monomer theretoward, thereby speeding up the reaction of the protected monomer with the deprotected monomer.

In embodiments, the copolymer is a biopolymer, preferably a nucleic acid strand, more preferably a deoxyribonucleic acid strand.

In embodiments, after step b (or c if present), the method may further comprise d. capping unreacted deprotected monomers, oligomers, or polymers by: i. causing the control unit (14) to pilot the flow control system (7) so that:
- a fifth flow rate of the washing solution, lower than a sixth flow rate of the washing solution, is delivered from the first reservoir (6a) to the one or more reaction chambers (2),
- a second flow rate of a capping solution, higher than a first flow rate of the capping solution, is delivered from one of the further reservoirs (6d, 6e) to the one or more reaction chambers (2), and
ii. causing the control unit (14) to pilot the flow control system (7) so that:
- the sixth flow rate of the washing solution, is delivered from the first reservoir (6a) to the one or more reaction chambers (2),
- the first flow rate of the capping solution, is delivered from said one of the further reservoirs (6d, 6e) to the one or more reaction chambers (2).

Preferably, step d. i. is performed so that the second flow rate of the capping solution is delivered from the one of the further reservoirs (6d, 6e) until the electrode (5) is in physical contact with this solution, followed by slowing down (e.g., down to the first flow rate) or stopping the delivery of this solution, thereby keeping the electrode (5) in physical contact with this solution for from 1s to 600s before step d.ii is performed.

The capping solution can for instance be adapted so that the capped polymers can be distinguished or separated from uncapped polymers.

In embodiments, after step b (or c if present, or d if present), the method may further comprise e. stabilizing the reaction product obtained in step b by
-i. causing the control unit (14) to pilot the flow control system (7) so that:
   - a seventh flow rate of the washing solution, lower than an eighth flow rate of the washing solution, is delivered from one of the further reservoirs (6d, 6e) to the one or more reaction chambers (2),
   - a second flow rate of a stabilizing solution, higher than a first flow rate of the stabilizing solution, is delivered from one of the further reservoirs (6d, 6e) to the one or more reaction chambers (2), and
ii. causing the control unit (14) to pilot the flow control system (7) so that:
   - the eighth flow rate of the washing solution, is delivered from the first reservoir (6a) to the one or more reaction chambers (2),
   - the first flow rate of the stabilizing solution, is delivered from said one of the further reservoirs (6d, 6e) to the one or more reaction chambers (2).

When the polymer is a polynucleotide strand, the stabilizing solution is typically an oxidation solution suitable for oxidizing the phosphite triester backbone of the reaction product obtained in step b.

Preferably, step e. i. is performed so that the second flow rate of the stabilizing solution is delivered from the one of the further reservoirs (6d, 6e) until the electrode (5) is in physical contact with this solution, followed by slowing down (e.g., down to the first flow rate) or stopping the delivery of this solution, thereby keeping the electrode (5) in physical contact with this solution for from 1s to 600s, preferably 1s to 10s, before step d.ii is performed.

Typically, the first, third, fifth, and seventh flow rates of the washing solution are all equal or within 5% of one another. This is, however, optional. It is advantageous as it simplifies the system. Typically, the second, fourth, sixth, and eigth flow rates of the washing solution are all equal or within 5% of one another. This is, however, optional. It is advantageous as it simplifies the system. Typically, the first, third, fifth, and seventh flow rates of the washing solution, the first flow rate of the deprotecting solution, the first flow rate of the protected monomer solution, the first flow rate of the activator solution, and the first flow rate of the capping solution are all equal or within 5% of one another. This is, however, optional. It is advantageous as it simplifies the system. Typically, the second, fourth, sixth, and eighth flow rate of the washing solution, the second flow rate of the deprotecting solution, the second flow rate of the protected monomer solution, the second flow rate of the activator solution, and the second flow rate of the capping solution are all equal or within 5% of one another. This is, however, optional. It is advantageous as it simplifies the system.

Any feature of the second aspect may be as correspondingly described in any embodiment of the first aspect.

In a third aspect, the present invention relates to a computer program comprising instructions to cause the control unit of the system of any embodiment of the first aspect to execute the steps of the method according to any embodiment of the second aspect.

Any feature of the third aspect can be as correspondingly described for the first aspect or the second aspect.

In a fourth aspect, the present invention relates to a computer-readable medium having stored thereon the computer program according to any embodiment of the third aspect.

In a fifth aspect, the present invention relates to an electrode comprising a graphene oxide on a surface thereof.

Solid-phase DNA/RNA synthesis relies on the attachment of a first deoxynucleoside triphosphate (dNTP) to hydroxyl moieties (-OH) of a solid support (e.g. control porosity glass (CPG), polystyrene beads) where the density of OH groups present at the surface effects the density of the resulting oligonucleotide sequences. The same principle applies to electrically controlled oligonucleotides synthesis during which dNTPs addition takes place at the surface of an electrode. The native oxide of a metal electrode (e.g platinum, ruthenium, palladium, etc.) can support synthesis. However, these oxides can be unstable during electrode operation. Semi-conductor electrode materials such as polysilicon or ceramics such as indium tin oxide (ITO) also present high-density of -OH functionalities but are difficult to process, do not readily support faradaic electrochemical reactions, and have higher impedance than their metal counter-parts. Hydroxyl groups can be introduced by wet chemistry, by depositing a functional adlayer (e.g. CPG/polymer composite, a sucrose polymer ), or by covalently modifying the electrodes with an organic monolayer (e.g. self-assembled monolayer of silane or alkanethiols, electrochemically grafted diazoniums ). These chemical modifications are carried out in liquids and require lengthy incubation and washing steps and are therefore cumbersome and difficult to scale up for manufacturing. Furthermore, these wet modification steps need to be carefully optimized and tightly controlled to avoid electrode blocking (e.g. thickness, density, porosity) that would prevent oligonucleotide synthesis. A critical step in oligonucleotide synthesis is the deprotection of the growing oligonucleotide strand using acidic conditions. This can be achieved by electrochemically oxidizing chemical compounds, that will release protons upon oxidation (e.g. quinones, benzidines, NAD/H, FAD/H, etc). The efficiency of the deprotection step depends strongly on the diffusion of the chemical compound to the electrode and will be hampered by any organic layer present at its surface. However, nanoelectrode surface modification based on wet processes can be limited as SAMs or grafted diazonium salts will preferentially attach at the metal grain boundaries. Grain size can be tens of nanometers in size and only a fraction of a nanoelectrode surface will bear -OH group, therefore Solid phase DNA/RNA synthesis relies on the attachment of a first deoxynucleoside triphosphate (dNTP) to hydroxyl moieties (-OH) of a solid support (e.g. control porosity glass (CPG), polystyrene beads) where the density of OH groups present at the surface effects the density of the resulting oligonucleotide sequences. Hence, there is a need for a scalable method to conveniently introduce high densities of hydroxyl groups at an electrode surface with limited impact on the electrode performances and support electrochemical synthesis of oligonucleotide sequences. A graphene oxide on a surface of an electrode as proposed by the fifth aspect of the present invention is advantageous in copolymer electrochemical synthesis applications because graphene oxide comprises -OH groups that facilitate the covalent attachment of a monomer (e.g. a nucleotide) thereon. In particular, polynucleotide synthesis benefits greatly from the presence of OH groups on the electrode to initiate attachment of a first nucleoside triphosphate thereto. The presence of this first monomer, on the surface of the graphene oxide, promotes the subsequent sequential attachment of other monomers to create a sequence of monomers. Providing -OH groups on an electrode typically leads to a detrimental electrical isolation of that electrode. This is typically the case for most coatings aiming at providing such -OH groups on electrodes. The graphene oxide provided in the fifth aspect, however, greatly limits electrode insulation. Moreover, it provides a high density of -OH groups. Furthermore, it is compatible with nanoelectrode array modification, unlike wet-based chemistries. Also, the graphene oxide provided in the fifth aspect can be easily scaled up and the -OH density it provides is independent of the electrode grain size. The density of -OH groups on graphene oxide is approximately 10¹⁵/cm², i.e. 100,000 times higher than using diazonium salts (approx. 10¹⁰/cm²), is independent of the underlying metal grain size and consequently not affected by electrode size. Also, the graphene oxide provided in the fifth aspect can support electrochemical reactions at its surface. Typically, graphene oxide is provided on an electrode by first growing graphene on the electrode, followed by oxidizing the formed graphene into graphene oxide, thereby introducing - OH groups. The growth process of the graphene is scalable, guarantees that graphene is only deposited at the electrode surface, can be realized at the wafer level, and does not require any wet chemistry. Preferably, the metal forming the electrode is Pt or Ru. This is advantageous because graphene can be selectively grown as mono or polylayers on such metals.

### Example: graphene oxide formation on an electrode:

The graphene growth on a Pt electrode was performed at 620°C for 2.5 min at 25 mbar in a CH₄(10 sccm)/H₂(10 sccm)/Ar(960 sccm) environment.

The grown graphene layer is then oxidized as follow. A UVO-Cleaner^{®} Model 144AX from Jelight company was used to carry out a UV/ozone treatment. Process conditions included an oxygen gas flow of 300 1/h, no additional sample heating, the reaction chamber at room temperature and atmospheric pressure, and a mercury lamp as UV source (Power settings: 100-120 V, 60 Hz) that produces UV light of 189.4 nm and 253.7 nm. The total treatment comprised a process step in which the mercury lamp was activated and thus ozone generated, and a fixed exhaust time of 6 minutes to remove all ozone form the reaction chamber. An electrode having a graphene oxide layer thereon resulted.

### Example: Using a system in accordance with the present invention in biological synthesis

A system such as for example described in any embodiment of the first aspect, may for instance be used in the synthesis of a (synthetic) polynucleotide (e.g., a DNA strand), or another (bio)molecule. A method for expanding one or more protected polynucleotide strands may for example start with attaching a first protected polynucleotide monomer, oligomer, or polymer to a surface of the one or more individually addressable electrodes. This first protected polynucleotide monomer, oligomer, or polymer can be the same in each reaction site or it can be different in some reaction sites and the same in other reaction sites. Next, one or more reagents for deprotecting the polynucleotide strands may be provided in the reaction medium (e.g. a proton-generation agent, such hydroquinone, for an acid-based deprotection).

A number of electrodes where a particular nucleotide is to be added can then be selected and addressed accordingly (e.g. the corresponding electrodes can be activated and, optionally, the surrounding electrodes can be set to be counteractive). For instance, one or more electrodes can electrochemically oxidize hydroquinone to benzoquinone, thereby producing protons and locally lowering the pH. Migration of the protons and other reaction products outside the reaction sites in which they are formed is however hindered by walls of a perforated cover layer and/or by the setting of the surrounding electrodes to be counteractive, so that the protons remain localized to the reaction sites. Accordingly, a change in pH is not observed in reaction sites not comprising the selected one or more electrodes. By doing so, the deprotection reaction is locally enabled and the selected polynucleotide strands can be deprotected specifically, while leaving the other polynucleotide strands protected. This allows controlling, through setting the electrodes, the reaction conditions (e.g. pH) in each reaction site individually, thereby across the plurality of reaction sites of the system managing where a reaction is enabled and where it is disabled. A derivative of the nucleotide e.g. bearing a further protective group can then be brought into the reaction medium and be reacted with the deprotected strands, resulting in selectively expanded strands which, again, bear a protective group. After washing away the nucleotide derivative, the procedure can be restarted e.g. in order to add another nucleotide to the polynucleotide strand(s) and it can be repeated an arbitrary number of times to yield DNA strands with an arbitrary sequence. Note in particular that, since the strands to be expanded can be selected in every instance of the procedure, the sequence of polynucleotide strands need not be the same. Indeed, the polynucleotide strand in each reaction site may have a unique sequence. As such, the system can be used to make a polynucleotide data storage.

Herebelow, a flow sequence for adding one particular polynucleotide phosphormidite (e.g., one of A, C, G, and T in the case of DNA) to a growing polynucleotide strand is described. This sequence can be repeated a number of times with the same or a different polynucleotide phosphormidite until a desired sequence is obtained.
1. A detritylation step (DET) is performed, in which the protective dimethoxytrityl (DMT) groups are removed selectively from those polymer strands onto which the next building block must be attached (e.g., in phosphoramidite synthesis, the removal of the DMT group results in a free -OH groups, onto which an activated phosphoramidite can couple). This happens by
   1.1. the flow rate of the washing solution is set to low, and
   1.2. setting the flow rate of the detritylation solution (e.g., hydroquinone/benzoquinone/lutidine in acetonitrile/MeOH) to high, to fill the supercells with the solution (FDS), and
   1.3. enabling the correct set of electrodes (MUX), followed by
   1.4. applying an electric potential or current to those electrodes (SMU), as to electrochemically alter the local (i.e., in proximity to the enabled electrode(s)) conditions (e.g., to increase the acidity) for enough time as to achieve >99% of DMT removal. The way to achieve locality (e.g., continuous voltage/current) depends on the conditions within the reaction chamber (e.g., continuous or stopped flow, chamber height), and the electrode configuration (e.g., working electrode in wells, counter-electrode far away or surrounding each electrode). This is followed by
   1.5. washing with a solvent (e.g., acetonitrile) to remove any DET solution from the supercells by setting the flow rate of the DET solution to low, and the wash solution to high
2. A coupling step (CPL), in which the specific polymer building block is attached to the freshly DMT-free polymers. To this end, a polymer building block solution (e.g., A, C, T, or G) is flushed, together with an activator solution, into the supercells by
   2.1. setting the flow rate of the washing solution to low, and
   2.2. setting the flow rates of the right building block and the activator solutions to high. Both solutions will then mix on the MFC, prior to entering the supercells. The coupling can then occur for a given amount of time (typically in from 1s to 600s), during which the flow is ideally reduced or stopped to reduce reagent consumption. Intermittent refreshment of the solution is possible to improve the CPL yield. Followed by
   2.3. washing with a solvent (e.g., acetonitrile) to remove any CPL solution from the supercells by setting the flow rate of the CPL solution to low, and the wash solution to high
3. A capping step (CAP), in which any non-reacted -OH groups are permanently blocked. This step is optional, as it does not contribute to the growing polymer itself. However, it is a means to reduce "deletion" errors in the synthesized polymers, and hence improves overall quality. It is done by
   3.1. setting the flow rate of the washing solution to low, and
   3.2. setting the flow rates of the CAP solution to high. The capping can then occur for a given amount of time (typically from 1s to 10s), during which the flow is ideally reduced or stopped to reduce reagent consumption. Followed by
   3.3. washing with a solvent (e.g., acetonitrile) to remove any CAP solution from the supercells by setting the flow rate of the CAP solution to low, and the wash solution to high
4. An oxidation step (OXI), in which the phosphite triester backbone of added building block is oxidized into a more stable tetracoordinated phosphate triester. This step is typical when the polymer to be synthesized is a polynucleotide. It is done by
   4.1. setting the flow rate of the washing solution to low, and
   4.2. setting the flow rates of the OXI solution to high. The oxidation can then occur for a given amount of time (typically from 1s to 10s), during which the flow is ideally reduced or stopped to reduce reagent consumption. Followed by
   4.3. washing with a solvent (e.g., acetonitrile) to remove any OXI solution from the supercells by setting the flow rate of the OXI solution to low, and the wash solution to high

It is to be understood that although preferred embodiments, specific constructions and configurations, as well as materials, have been discussed herein for devices according to the present invention, various changes or modifications in form and detail may be made without departing from the scope of this invention. For example, steps may be added or deleted to methods described within the scope of the present invention.

## Claims

1. A system (1) for the electrochemical synthesis of polymers, comprising:
a. one or more reaction chambers (2), each chamber (2) comprising:
i. a reaction chamber inlet (3),
ii. a reaction chamber outlet (4),
iii. a plurality of reaction sites, each reaction site comprising one or more individually addressable electrodes (5) for controlling a chemical reaction in that reaction site of the reaction chamber (2),
b. a plurality of pressurizeable reservoirs (6) for containing liquids,
c. a plurality of flow control systems (7) for selecting a flow rate at which a liquid will be delivered from one or more of said plurality of reservoirs (6) to the flow control system outlet (9a, 9b), comprising:
i. at least one flow control system inlet (8), wherein each reservoir (6) is fluidically coupled upstream to a flow control system inlet (8),
ii. at least one flow control system outlet (9a, 9b),
d. a microfluidic structure (17) comprising:
i. a plurality of microfluidic structure inlets 10a, 10b), each fluidically coupled downstream to a flow control system outlet (9a, 9b),
ii. at least one microfluidic structure outlet (11a, 11b) per reaction chamber (2), each microfluidic structure outlet (11a, 11b) being fluidically coupled upstream to a reaction chamber inlet (3a, 3b),
e. an addressing system (13) configured for addressing the electrodes (5) individually, and
f. a control unit (14) configured for piloting:
i. the addressing system (13), and
ii. the at least one flow control system (7);
**characterized in that**, the microfluidic structure (17) is fluidically connected downstream to all flow control systems (7), wherein at least one of said flow control systems (7) is set to deliver to the microfluidic structure (17) a liquid at a relatively higher flow rate, higher than a relatively lower flow rate of the one or more liquids delivered by the remaining flow control systems (7), and wherein the microfluidic structure (17) is configured for distributing between all of the one or more reaction chambers (2) said liquid delivered at a relatively high flow rate and for diverting away from all reaction chambers (2) the other liquids delivered at a relatively lower flow rate.

2. The system (1) according to claim 1, wherein the at least one flow control system (7) is adapted for selecting between delivering a liquid to the flow control system outlet (9a, 9b) at a first flow rate and delivering the liquid to the flow control system outlet (9a, 9b) at a second flow rate, different from the first flow rate, non-zero, and preferably at least five time smaller than the first flow rate.

3. The system (1) according to claim 2 wherein the at least one flow control system (7) comprises a three-way valve (18) comprising a three-way valve inlet fluidically coupled downstream to the flow control system inlet (8), a first three-way valve outlet fluidically coupled upstream to the flow control system outlet (9), and a second three-way valve outlet fluidically coupled upstream to the flow control system outlet (9), wherein the flow control system (7) is configured for delivering the liquid to the flow control system outlet (9) at the first flow rate when the first three-way valve outlet is open and the second three-way valve outlet is closed, and at the second flow rate when the first three-way valve outlet is closed and the second three-way valve outlet is open.

4. The system (1) according to claim 2 or claim 3, wherein the at least one flow control system (7) is adapted for selecting between not delivering the liquid to the flow control system outlet (9), delivering the liquid to the flow control system outlet (9) at the first flow rate, or delivering the liquid to the flow control system outlet (9) at the second flow rate.

5. The system (1) according to claim 4, wherein the at least one flow control system (7) comprises a two-way valve (15) comprising a two-way valve inlet fluidically coupled downstream to the flow control system inlet (8) and a two-way valve outlet fluidically coupled upstream to the flow control system outlet (9), wherein the flow control system (7) is configured for not delivering the liquid to the flow control system outlet (9) when the two-way valve (15) is closed and for delivering the liquid to the flow control system outlet (9) when the two-way valve (15) is open.

6. The system (1) according to claim 5 wherein each reservoir (6) is fluidically coupled upstream to a different flow control system (7).

7. The system (1) according to any one of the preceding claims further comprising a measuring system (16) configured for measuring an electrical property in a reaction chamber (2) at at least one of said reaction sites.

8. The system (1) according to claim 7, wherein the control unit (14) is further configured for receiving the measurement of the electrical property, or a signal depending on this measurement, from the measuring system (16), and using this electrical property or signal to pilot the addressing system (13) and/or the at least one flow control system (7).

9. The system (1) according to any one of the preceding claims, wherein the individually addressable electrodes (5) comprise a graphene oxide on a surface thereof.

10. A method for the electrochemical synthesis of a polymer in a reaction chamber (2) of the system (1) according to any one of claims 1 to 9 wherein:
• the one or more individually addressable electrodes (5) of at least one of said reaction sites have a first protected monomer, oligomer, or polymer, attached to a surface thereof, and
• the plurality of reservoirs (6) includes a first reservoir (6a) comprising a washing solution, a second reservoir (6b) comprising a deprotecting solution, and a plurality of further reservoirs (6d, 6e), each containing a different protected monomer solution,
said method comprising:
a. deprotecting the protected monomer, oligomer, or polymer by:
i. causing the control unit (14) to pilot the plurality of flow control systems (7) so that:
- a first flow rate of the washing solution, lower than a second flow rate of the washing solution, is delivered from the first reservoir (6a),
- a second flow rate of the deprotecting solution, higher than a first flow rate of the deprotecting solution, is delivered from the second reservoir (6b),
ii. causing the control unit (14) to pilot the addressing system (13) so that a potential is applied, or a current is delivered, to said one or more individually addressable electrodes (5) of said at least one of said reaction sites, thereby deprotecting the first protected monomer, oligomer, or polymer, wherein step i. and ii. overlap,
iii. then, causing the control unit (14) to pilot the at least one flow control system (7) so that:
- the second flow rate of the washing solution is delivered from the first reservoir (6a), and
- the first flow rate of the deprotecting solution is delivered from the second reservoir (6b),
b. reacting a protected monomer with the deprotected monomer, oligomer, or polymer by:
i. causing the control unit (14) to pilot the at least one flow control system (7) so that:
- a third flow rate of the washing solution, lower than a fourth flow rate of the washing solution, is delivered from the first reservoir (6a),
- a second flow rate of a protected monomer solution, higher than a first flow rate of the protected monomer solution, is delivered from one of the further reservoirs (6d, 6e),
ii. then, causing the control unit (14) to pilot the at least one flow control system (7) so that:
- the fourth flow rate of the washing solution is delivered from the first reservoir (6a), and
- the first flow rate of the protected monomer solution is delivered from said one of the further reservoir (6d, 6e) of step b. i., and
c. optionally repeating steps a and b in sequence one or more time.

11. The method according to claim 10, wherein the system (1) for electrochemical synthesis of polymers is according to claim 7, wherein:
• step a comprises a sub-step of causing the control unit (14) to pilot the measuring system (16) so that an electrical property in the reaction chamber (2) is measured at said at least one of said reaction sites, and wherein the presence or absence of a further step a.iv. of cycling steps a.i. to a.iii. a number of times depends on the measured electrical property, and if the further step a.iv. is present, the number of cycles depends on the measured electrical property, and/or
• step b comprises a sub-step b.iii.of causing the control unit (14) to pilot the measuring system (16) so that an electrical property in the reaction chamber (2) is measured at least at said at least one of said reaction sites, and wherein the presence or absence of a further step b.iii. of cycling steps b.i. and b.ii. a number of times depends on the measured electrical property, and if the further step b.iii. is present, the number of cycles depends on the measured electrical property.

12. The method according to claim 10 or claim 11, wherein step b. i. is performed so that the second flow rate of the protected monomer solution is delivered from the one of the further reservoirs (6d, 6e) until the electrode (5) is in physical contact with this solution, followed by slowing down or stopping the delivery of this solution, thereby keeping the electrode (5) in physical contact with this solution for from 1s to 600s before step b.ii is performed.

13. The method according to any one of claims 10 to 12, wherein step b comprises a step i', between step i and step ii, of causing the control unit (14) to pilot the addressing system (13) so as to activate said one or more individually addressable electrodes (5) of said at least one of said reaction sites in such a way as to **attract** the protected monomer theretoward, thereby speeding up the reaction of the protected monomer with the deprotected monomer.

14. The method according to any one of claims 10 to 13, wherein the polymer is a biopolymer, preferably a deoxyribonucleic acid strand.

## Patentansprüche

1. Ein System (1) zur elektrochemischen Synthese von Polymeren, umfassend:
a. eine oder mehrere Reaktionskammern (2), wobei jede Kammer (2) umfasst:
i. einen Reaktionskammereinlass (3),
ii. einen Reaktionskammerauslass (4),
iii. eine Vielzahl von Reaktionsstellen, wobei jede Reaktionsstelle eine oder mehrere einzeln ansteuerbare Elektroden (5) zum Steuern einer chemischen Reaktion in dieser Reaktionsstelle der Reaktionskammer (2) umfasst,
b. eine Vielzahl von druckbeaufschlagbaren Behältern (6) zum Enthalten von Flüssigkeiten,
c. eine Vielzahl von Flusssteuerungssystemen (7) zum Auswählen einer Flussrate, mit der eine Flüssigkeit aus einem oder mehreren der Vielzahl von Behältern (6) zum Auslass (9a, 9b) des Flusssteuerungssystems abgegeben wird, umfassend:
i. mindestens einen Einlass (8) des Flusssteuerungssystems, wobei jeder Behälter (6) strömungstechnisch stromaufwärts mit einem Einlass (8) des Flusssteuerungssystems gekoppelt ist,
ii. mindestens einen Auslass (9a, 9b) des Flusssteuerungssystems,
d. eine mikrofluidische Struktur (17), umfassend:
i. eine Vielzahl von mikrofluidischen Struktureinlässen 10a, 10b), die jeweils strömungstechnisch stromabwärts mit einem Auslass (9a, 9b) des Flusssteuerungssystems gekoppelt sind,
ii. mindestens einen Auslass (11a, 11b) der mikrofluidischen Struktur je Reaktionskammer (2), wobei jeder Auslass (11a, 11b) der mikrofluidischen Struktur strömungstechnisch stromaufwärts mit einem Einlass (3a, 3b) der Reaktionskammer gekoppelt ist,
e. ein Ansteuerungssystem (13), das zum individuellen Ansteuern der Elektroden (5) konfiguriert ist, und
f. eine Steuereinheit (14), die zum Ansteuern konfiguriert ist, von:
i. dem Ansteuerungssystem (13), und
ii. dem mindestens einen Flussstseuerungssystem (7);
**dadurch gekennzeichnet, dass** die mikrofluidische Struktur (17) strömungstechnisch stromabwärts mit allen Flusssteuerungssystemen (7) verbunden ist, wobei mindestens eines der Flusssteuerungssysteme (7) eingestellt ist, um der mikrofluidischen Struktur (17) eine Flüssigkeit mit einer relativ höheren Flussrate zuzuführen, die höher ist als eine relativ niedrigere Flussrate der einen oder mehreren von den übrigen Flusssteuerungssystemen (7) zugeführten Flüssigkeiten, wobei die mikrofluidische Struktur (17) zum Verteilen zwischen allen der einen oder mehreren Reaktionskammern (2) der mit relativ hoher Durchflussrate zugeführten Flüssigkeit, und zum Ableiten von allen Reaktionskammern (2) der anderen mit einer relative niedrigen Flussrate zugeführten Flüssigkeiten konfiguriert ist.

2. Das System (1) nach Anspruch 1, wobei das mindestens eine Flusssteuerungssystem (7) zum Auswählen zwischen Zuführen einer Flüssigkeit zum Auslass (9a, 9b) des Flusssteuerungssystems mit einer ersten Flussrate und Zuführen der Flüssigkeit zum Auslass (9a, 9b) des Flusssteuerungssystems mit einer zweiten, von der ersten Flussrate verschiedenen, von Null verschiedenen Flussrate und vorzugsweise mindestens fünfmal kleiner als die erste Durchflussrate angepasst ist.

3. Das System (1) nach Anspruch 2, wobei das mindestens eine Flussteuerungssystem (7) ein Dreiwegeventil (18) umfasst, das einen Dreiwegeventil-Einlass umfasst, der strömungstechnisch stromabwärts mit dem Einlass (8) des Flusssteuerungssystems gekoppelt ist, einen ersten Dreiwegeventil-Auslass, der strömungstechnisch stromaufwärts mit dem Auslass (9) des Flusssteuerungssystems gekoppelt ist, und einen zweiten Dreiwegeventil-Auslass, der strömungstechnisch stromaufwärts mit dem Auslass (9) des Flusssteuerungssystems gekoppelt ist, wobei das Flusssteuerungssystem (7) zum Zuführen der Flüssigkeit mit der ersten Flussrate zum Auslass (9) des Flusssteuerungssystems konfiguriert ist, wenn der erste Dreiwegeventil-Auslass offen und der zweite Dreiwegeventil-Auslass geschlossen ist, und mit der zweiten Flussrate, wenn der erste Dreiwegeventil-Auslass geschlossen und der zweite Dreiwegeventil-Auslass offen ist.

4. Das System (1) nach Anspruch 2 oder Anspruch 3, wobei das mindestens eine Flusssteuerungssystem (7) zum Auswählen zwischen dem Nicht-Zuführen der Flüssigkeit zum Auslass (9) des Flusssteuerungssystems, dem Zuführen der Flüssigkeit zum Auslass (9) des Flusssteuerungssystems mit der ersten Flussrate oder dem Zuführen der Flüssigkeit zum Auslass (9) des Flusssteuerungssystems mit der zweiten Flussrate angepasst ist.

5. Das System (1) nach Anspruch 4, wobei das mindestens eine Flussteuerungssystem (7) ein Zweiwegeventil (15) umfasst, das einen Zweiwegeventil-Einlass umfasst, der strömungstechnisch stromabwärts mit dem Einlass (8) des Flusssteuerungssystems gekoppelt ist, und einen Zweiwegeventil-Auslass, der strömungstechnisch stromaufwärts mit dem Auslass (9) des Flusssteuerungssystems gekoppelt ist, wobei das Flusssteuerungssystem (7) zum Nicht-Zuführen der Flüssigkeit zum Auslass (9) des Flusssteuerungssytems konfiguriert ist, wenn das Zweiwegeventil (15) geschlossen ist und zum Zuführen der Flüssigkeit zum Auslass (9) des Flusssteuerungssytems, wenn das Zweiwegeventil (15) offen ist.

6. Das System (1) nach Anspruch 5, wobei jeder Behälter (6) strömungstechnisch stromaufwärts mit einem anderen Flusssteuerungssystem (7) gekoppelt ist.

7. Das System (1) nach einem der vorstehenden Ansprüche, weiter umfassend ein Messsystem (16), das zum Messen einer elektrischen Eigenschaft in einer Reaktionskammer (2) an mindestens einer der Reaktionsstellen konfiguriert ist.

8. Das System (1) nach Anspruch 7, wobei die Steuereinheit (14) weiter zum Empfangen der Messung der elektrischen Eigenschaft oder eines von dieser Messung abhängigen Signals vom Messsystem (16) und Verwenden dieser elektrischen Eigenschaft oder dieses Signals konfiguriert ist, um das Ansteuerungssystem (13) und/oder das mindestens eine Flusssteuerungssystem (7) anzusteuern.

9. Das System (1) nach einem der vorstehenden Ansprüche, wobei die einzeln ansteuerbaren Elektroden (5) auf einer Oberfläche davon ein Graphenoxid umfassen.

10. Ein Verfahren zur elektrochemischen Synthese eines Polymers in einer Reaktionskammer (2) des Systems (1) nach einem der Ansprüche 1 bis 9, wobei:
- die eine oder mehrere einzeln ansteuerbare Elektroden (5) mindestens einer der Reaktionsstellen ein erstes geschütztes Monomer, Oligomer oder Polymer aufweisen, das an einer Oberfläche davon angebracht ist, und
- die Vielzahl von Behältern (6) einen ersten Behälter (6a), der eine Waschlösung umfasst, einen zweiten Behälter (6b), der eine Entschützungslösung umfasst, und eine Vielzahl von weiteren Behältern (6d, 6e) beinhaltet, die jeweils eine unterschiedliche geschützte Monomerlösung enthalten,
wobei das Verfahren umfasst:
a. Entschützen des geschützten Monomers, Oligomers oder Polymers durch:
i. Veranlassen der Steuereinheit (14), die Vielzahl der Flusssteuerungssystemen (7) anzusteuern, sodass:
- eine erste Flussrate der Waschlösung, die niedriger ist als eine zweite Flussrate der Waschlösung, aus dem ersten Behälter (6a) zugeführt wird,
- eine zweite Flussrate der Entschützungslösung, die höher ist als eine erste Flussrate der Entschützungslösung, aus dem zweiten Behälter (6b) zugeführt wird,
ii. Veranlassen der Steuereinheit (14), das Ansteuerungssystem (13) anzusteuern, sodass an die eine oder mehrere einzeln ansteuerbaren Elektroden (5) der mindestens einen der Reaktionsstellen ein Potential angelegt oder ein Strom zugeführt wird, wodurch das erste geschützte Monomer, Oligomer oder Polymer entschützt wird, wobei sich Schritte i. und ii. überschneiden,
iii. danach Veranlassen der Steuereinheit (14), das mindestens eine Flusssteuerungssystem (7) anzusteuern, sodass:
- die zweite Flussrate der Waschlösung aus dem ersten Behälter (6a) zugeführt wird, und
- die erste Flussrate der Entschützungslösung aus dem zweiten Behälter (6b) zugeführt wird,
b. Reagieren lassen eines geschützten Monomers mit dem entschützten Monomer, Oligomer oder Polymer durch:
i. Veranlassen der Steuereinheit (14), das mindestens eine Flusssteuerungssystem (7) anzusteuern, sodass:
- eine dritte Flussrate der Waschlösung, die niedriger ist als eine vierte Flussrate der Waschlösung, aus dem ersten Behälter (6a) zugeführt wird,
- eine zweite Flussrate einer geschützten Monomerlösung, die höher ist als eine erste Flussrate der geschützten Monomerlösung, aus einem der weiteren Behälter (6d, 6e) zugeführt wird,
ii. danach Veranlassen der Steuereinheit (14), das mindestens eine Flusssteuerungssystem (7) anzusteuern, sodass:
- die vierte Flussrate der Waschlösung aus dem ersten Behälter (6a) zugeführt wird, und
- die erste Flussrate der geschützten Monomerlösung aus einem der weiteren Behälter (6d, 6e) aus Schritt b.i. zugeführt wird, und c. optional Wiederholen der Schritte a und b nacheinander einmal oder mehrmals.

11. Das Verfahren nach Anspruch 10, wobei das System (1) zur elektrochemischen Synthese von Polymeren nach Anspruch 7 ist, wobei:
- Schritt a einen Teilschritt zum Veranlassen der Steuereinheit (14) umfasst, das Messsystem (16) anzusteuern, sodass eine elektrische Eigenschaft in der Reaktionskammer (2) an mindestens einer der Reaktionsstellen gemessen wird, und wobei das Vorhandensein oder Fehlen eines weiteren Schritts a.iv. der Zyklisierungsschritte a.i. bis a.iii. eine Anzahl von malen von der gemessenen elektrischen Eigenschaft abhängt, und falls der weitere Schritt a.iv. vorhanden ist, die Anzahl an Zyklen von der gemessenen elektrischen Eigenschaft abhängt, und/oder
- Schritt b einen Teilschritt b.iii. zum Veranlassen der Steuereinheit (14) umfasst, das Messsystem (16) anzusteuern, sodass eine elektrische Eigenschaft in der Reaktionskammer (2) mindestens an der mindestens einen der Reaktionsstellen gemessen wird, und wobei das Vorhandensein oder Fehlen eines weiteren Schritts b.iii. der Zyklisierungsschritte b.i. und b.ii. eine Anzahl von malen von der gemessenen elektrischen Eigenschaft abhängt, und falls der weitere Schritt b.iii. vorhanden ist, die Anzahl an Zyklen von der gemessenen elektrischen Eigenschaft abhängt.

12. Das Verfahren nach Anspruch 10 oder Anspruch 11, wobei Schritt b.i. durchgeführt wird, sodass die zweite Flussrate der geschützten Monomerlösung aus einem der weiteren Behälter (6d, 6e) zugeführt wird, bis die Elektrode (5) in physischem Kontakt mit dieser Lösung steht, gefolgt von einer Verlangsamung oder einem Stopp der Zuführung dieser Lösung, wodurch die Elektrode (5) 1s bis 600 s lang in physischem Kontakt mit dieser Lösung gehalten wird, bevor Schritt b.ii durchgeführt wird.

13. Das Verfahren nach einem der Ansprüche 10 bis 12, wobei Schritt b einen Schritt i' zwischen Schritt i und Schritt ii zum Veranlassen der Steuereinheit (14) umfasst, das Ansteuerungssystem (13) anzusteuern, um die eine oder mehrere einzeln ansteuerbare Elektroden (5) der mindestens einen der Reaktionsstellen zu aktivieren, sodass das geschützte Monomer dorthin **anzuziehen** und dadurch die Reaktion des geschützten Monomers mit dem entschützten Monomer zu beschleunigen.

14. Das Verfahren nach einem der Ansprüche 10 bis 13, wobei es sich bei dem Polymer um ein Biopolymer, vorzugsweise um einen Desoxyribonukleinsäurestrang, handelt.

## Revendications

1. Un système (1) pour la synthèse électrochimique de polymères, comprenant :
a. une ou plusieurs chambres de réaction (2), chaque chambre (2) comprenant :
i. une entrée de chambre de réaction (3),
ii. une sortie de chambre de réaction (4),
iii. une pluralité de sites de réaction, chaque site de réaction comprenant un ou plusieurs électrodes (5) adressables individuellement pour contrôler une réaction chimique dans ce site de réaction de la chambre de réaction (2),
b. une pluralité de réservoirs (6) pressurisables pour contenir des liquides,
c. une pluralité de systèmes de contrôle de débit (7) pour sélectionner un débit auquel un liquide sera délivré à partir d'un ou plusieurs desdits réservoirs (6) vers la sortie du système de contrôle de débit (9a, 9b), comprenant :
i. au moins une entrée de système de contrôle de débit (8), dans laquelle chaque réservoir (6) est couplé fluidiquement en amont à une entrée de système de contrôle de débit (8),
ii. au moins une sortie de système de contrôle de débit (9a, 9b),
d. une structure microfluidique (17) comprenant :
i. une pluralité d'entrées de structure microfluidique (10a, 10b), chacune étant couplée fluidiquement en aval à une sortie de système de contrôle de débit (9a, 9b),
ii. au moins une sortie de structure microfluidique (11a, 11b) par chambre de réaction (2), chaque sortie de structure microfluidique (11a, 11b) étant couplée fluidiquement en amont à une entrée de chambre de réaction (3a, 3b),
e. un système d'adressage (13) configuré pour adresser les électrodes (5) individuellement, et
f. une unité de contrôle (14) configurée pour piloter :
i. le système d'adressage (13), et
ii. ledit système de contrôle de débit (7) ;
**caractérisé en ce que** la structure microfluidique (17) est connectée fluidiquement en aval à tous les systèmes de contrôle de débit (7), dans lequel au moins un desdits systèmes de contrôle de débit (7) est réglé pour délivrer à la structure microfluidique (17) un liquide à un débit relativement plus élevé, supérieur à un débit relativement plus bas d'un ou plusieurs liquides délivrés par les autres systèmes de contrôle de débit (7), et dans lequel la structure microfluidique (17) est configurée pour distribuer entre toutes les chambres de réaction (2) ledit liquide délivré à un débit relativement élevé et pour détourner de toutes les chambres de réaction (2) les autres liquides délivrés à un débit relativement plus bas.

2. Le système (1) selon la revendication 1, dans lequel ledit système de contrôle de débit (7) est adapté pour sélectionner entre délivrer un liquide à la sortie du système de contrôle de débit (9a, 9b) à un premier débit et délivrer le liquide à la sortie du système de contrôle de débit (9a, 9b) à un second débit, différent du premier débit, non nul, et de préférence au moins cinq fois plus petit que le premier débit.

3. Le système (1) selon la revendication 2, dans lequel ledit système de contrôle de débit (7) comprend une vanne à trois voies (18) comprenant une entrée de vanne à trois voies couplée fluidiquement en aval à l'entrée du système de contrôle de débit (8), une première sortie de vanne à trois voies couplée fluidiquement en amont à la sortie du système de contrôle de débit (9), et une seconde sortie de vanne à trois voies couplée fluidiquement en amont à la sortie du système de contrôle de débit (9), dans lequel le système de contrôle de débit (7) est configuré pour délivrer le liquide à la sortie du système de contrôle de débit (9) à un premier débit lorsque la première sortie de vanne à trois voies est ouverte et la seconde sortie de vanne à trois voies est fermée, et audit second débit lorsque la première sortie de vanne à trois voies est fermée et la seconde sortie de vanne à trois voies est ouverte.

4. Le système (1) selon la revendication 2 ou 3, dans lequel ledit système de contrôle de débit (7) est adapté pour sélectionner entre ne pas délivrer le liquide à la sortie du système de contrôle de débit (9), délivrer le liquide à la sortie du système de contrôle de débit (9) à un premier débit, ou délivrer le liquide à la sortie du système de contrôle de débit (9) au second débit.

5. Le système (1) selon la revendication 4, dans lequel ledit système de contrôle de débit (7) comprend une vanne à deux voies (15) comprenant une entrée de vanne à deux voies couplée fluidiquement en aval à l'entrée du système de contrôle de débit (8) et une sortie de vanne à deux voies couplée fluidiquement en amont à la sortie du système de contrôle de débit (9), dans lequel le système de contrôle de débit (7) est configuré pour ne pas délivrer le liquide à la sortie du système de contrôle de débit (9) lorsque la vanne à deux voies (15) est fermée et pour délivrer le liquide à la sortie du système de contrôle de débit (9) lorsque la vanne à deux voies (15) est ouverte.

6. Le système (1) selon la revendication 5, dans lequel chaque réservoir (6) est couplé fluidiquement en amont à un système de contrôle de débit (7) différent.

7. Le système (1) selon l'une quelconque des revendications précédentes comprenant en outre un système de mesure (16) configuré pour mesurer une propriété électrique dans une chambre de réaction (2) à au moins un desdits sites de réaction.

8. Le système (1) selon la revendication 7, dans lequel l'unité de contrôle (14) est en outre configurée pour recevoir la mesure de la propriété électrique, ou un signal dépendant de cette mesure, du système de mesure (16), et utiliser cette propriété électrique ou ce signal pour piloter le système d'adressage (13) et/ou ledit système de contrôle de débit (7).

9. Le système (1) selon l'une quelconque des revendications précédentes, dans lequel les électrodes (5) adressables individuellement comprennent un oxyde de graphène sur une surface de celles-ci.

10. Un procédé pour la synthèse électrochimique d'un polymère dans une chambre de réaction (2) du système (1) selon l'une quelconque des revendications 1 à 9 dans lequel :
• le ou les électrodes (5) adressables individuellement d'au moins un desdits sites de réaction ont un premier monomère, oligomère ou polymère protégé, attaché à une surface de ceux-ci, et
• la pluralité de réservoirs (6) comprend un premier réservoir (6a) comprenant une solution de lavage, un second réservoir (6b) comprenant une solution de déprotection, et une pluralité d'autres réservoirs (6d, 6e), chacun contenant une solution de monomère protégé différente,
ledit procédé comprenant :
a. déprotéger le monomère, oligomère ou polymère protégé en :
i. amenant l'unité de contrôle (14) à piloter la pluralité de systèmes de contrôle de débit (7) de sorte que :
- un premier débit de la solution de lavage, inférieur à un second débit de la solution de lavage, est délivré à partir du premier réservoir (6a),
- un second débit de la solution de déprotection, supérieur à un premier débit de la solution de déprotection, est délivré à partir du second réservoir (6b),
ii. amenant l'unité de contrôle (14) à piloter le système d'adressage (13) de sorte qu'un potentiel soit appliqué, ou un courant soit délivré, audit ou auxdits électrodes (5) adressables individuellement dudit au moins un desdits sites de réaction, déprotégeant ainsi le premier monomère, oligomère ou polymère protégé, dans lequel l'étape i. et ii. se chevauchent,
iii. puis, amenant l'unité de contrôle (14) à piloter ledit système de contrôle de débit (7) de sorte que :
- le second débit de la solution de lavage est délivré à partir du premier réservoir (6a), et
- le premier débit de la solution de déprotection est délivré à partir du second réservoir (6b),
b. réagir un monomère protégé avec le monomère, oligomère ou polymère déprotégé en :
i. amenant l'unité de contrôle (14) à piloter ledit système de contrôle de débit (7) de sorte que :
- un troisième débit de la solution de lavage, inférieur à un quatrième débit de la solution de lavage, est délivré à partir du premier réservoir (6a),
- un second débit d'une solution de monomère protégé, supérieur à un premier débit de la solution de monomère protégé, est délivré à partir de l'un des autres réservoirs (6d, 6e),
ii. puis, amenant l'unité de contrôle (14) à piloter ledit système de contrôle de débit (7) de sorte que :
- le quatrième débit de la solution de lavage est délivré à partir du premier réservoir (6a), et
- le premier débit de la solution de monomère protégé est délivré à partir dudit l'un des autres réservoirs (6d, 6e) de l'étape b. i., et
c. répéter éventuellement les étapes a et b en séquence une ou plusieurs fois.

11. Le procédé selon la revendication 10, dans lequel le système (1) pour la synthèse électrochimique de polymères est selon la revendication 7, dans lequel :
• l'étape a comprend une sous-étape consistant à amener l'unité de contrôle (14) à piloter le système de mesure (16) de sorte qu'une propriété électrique dans la chambre de réaction (2) soit mesurée audit au moins un desdits sites de réaction, et dans lequel la présence ou l'absence d'une étape supplémentaire a.iv. de cyclage des étapes a.i. à a.iii. un certain nombre de fois dépend de la propriété électrique mesurée, et si l'étape supplémentaire a.iv. est présente, le nombre de cycles dépend de la propriété électrique mesurée, et/ou
• l'étape b comprend une sous-étape b.iii. consistant à amener l'unité de contrôle (14) à piloter le système de mesure (16) de sorte qu'une propriété électrique dans la chambre de réaction (2) soit mesurée au moins audit au moins un desdits sites de réaction, et dans lequel la présence ou l'absence d'une étape supplémentaire b.iii. de cyclage des étapes b.i. et b.ii. un certain nombre de fois dépend de la propriété électrique mesurée, et si l'étape supplémentaire b.iii. est présente, le nombre de cycles dépend de la propriété électrique mesurée.

12. Le procédé selon la revendication 10 ou 11, dans lequel l'étape b. i. est effectuée de sorte que le second débit de la solution de monomère protégé soit délivré à partir de l'un des autres réservoirs (6d, 6e) jusqu'à ce que l'électrode (5) soit en contact physique avec cette solution, suivi d'un ralentissement ou d'un arrêt de la délivrance de cette solution, maintenant ainsi l'électrode (5) en contact physique avec cette solution pendant de 1s à 600s avant que l'étape b.ii ne soit effectuée.

13. Le procédé selon l'une quelconque des revendications 10 à 12, dans lequel l'étape b comprend une étape i', entre l'étape i et l'étape ii, consistant à amener l'unité de contrôle (14) à piloter le système d'adressage (13) de manière à activer ledit ou lesdits électrodes (5) adressables individuellement dudit au moins un desdits sites de réaction de manière à attirer le monomère protégé vers ceux-ci, accélérant ainsi la réaction du monomère protégé avec le monomère déprotégé.

14. Le procédé selon l'une quelconque des revendications 10 à 13, dans lequel le polymère est un biopolymère, de préférence un brin d'acide désoxyribonucléique.
